(19) Europäisches Patentamt / European Patent Office / Office européen des brevets

(11) **EP 3 916 884 B1**

(12) **EUROPEAN PATENT SPECIFICATION**

(45) Date of publication and mention of the grant of the patent:
**11.10.2023 Bulletin 2023/41**

(21) Application number: **19911318.4**

(22) Date of filing: **30.08.2019**

(51) International Patent Classification (IPC):
$H01M\ 10/48^{(2006.01)}$    $G01R\ 31/392^{(2019.01)}$
$H02J\ 7/00^{(2006.01)}$    $G01R\ 31/3842^{(2019.01)}$
$G01R\ 31/389^{(2019.01)}$

(52) Cooperative Patent Classification (CPC):
**G01R 31/3842; G01R 31/389; G01R 31/392; H01M 10/48; H01M 10/486; H02J 7/005;** H02J 7/00032; H02J 2310/48; Y02E 60/10

(86) International application number:
**PCT/JP2019/034137**

(87) International publication number:
**WO 2020/152901 (30.07.2020 Gazette 2020/31)**

(54) **SECONDARY BATTERY MODULE REMAINING LIFE DIAGNOSIS METHOD AND REMAINING LIFE DIAGNOSIS SYSTEM**

VERFAHREN ZUR DIAGNOSE DER RESTLEBENSDAUER EINES SEKUNDÄRBATTERIEMODULS UND RESTLEBENSDAUERDIAGNOSESYSTEM

PROCÉDÉ DE DIAGNOSTIC DE DURÉE DE VIE RESTANTE DE MODULE DE BATTERIE SECONDAIRE ET SYSTÈME DE DIAGNOSTIC DE DURÉE DE VIE RESTANTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.01.2019 JP 2019007658**

(43) Date of publication of application:
**01.12.2021 Bulletin 2021/48**

(73) Proprietor: **Hitachi, Ltd.**
**Tokyo 100-8280 (JP)**

(72) Inventors:
• **YAMAUCHI, Shuko**
  **Tokyo 100-8280 (JP)**
• **INOUE, Takeshi**
  **Tokyo 100-8280 (JP)**
• **YAMAZOE, Takanori**
  **Tokyo 100-8280 (JP)**
• **MAKINO, Shigeki**
  **Tokyo 100-8280 (JP)**
• **KOMATSU, Daiki**
  **Tokyo 100-8280 (JP)**
• **IMAI, Shinji**
  **Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
**JP-A- 2013 118 757    JP-A- 2018 179 733**
**US-A1- 2015 369 873    US-A1- 2016 187 432**
**US-A1- 2018 204 393**

**Description**

Technical Field

The present invention relates to a method and system for diagnosing residual life of a secondary battery module.

Background Art

At present, global environmental problems gain prominent attention widely, reduction of carbon dioxide emission is called for in every situation to prevent global warming. From this background, substitution of motor vehicles using a gasoline engine that is a major source of carbon dioxide emission with hybrid electric vehicles or electric vehicles is in progress. Large secondary batteries that are a typical power supply for powering hybrid electric vehicles or electric vehicles are required to have high output and large capacity. Hence, rechargeable battery modules constituting such a large secondary battery are typically comprised of a plurality of battery cells connected in series or parallel.

Meanwhile, recently, there is an increasing number of homes in which inhabitants perform private power generation through solar power generation or wind-power generation and may sell surplus electricity, if present, to an electric power company. However, an increase in the amount of sold electricity in a power grid system makes the system voltage unstable. Hence, it is considered to implement load leveling by storing surplus electricity in a storage system and supplying electricity from the storage system when there is a shortage. It is also proposed to use electric vehicles for this load leveling.

For in-vehicle batteries, because battery performance influences traveling of the vehicle, lithium ion batteries that are high in performance and light in weight and are typically used. Hence, generally, the price of batteries used for vehicle traveling is high and the price of electric vehicles is also higher than gasoline vehicles of the corresponding class. Therefore, there is a request from users to want to continue to use and run electric vehicles for a longer period. Hence, it is important diagnose a battery deterioration level more properly and diagnose its residual life.

To know deterioration of an in-vehicle battery accurately, it is desirable to calculate resistance and capacitance of the battery by a charge/discharge test with a constant current. However, a deterioration diagnosis takes time, inter alia, because of that, after a battery has once been installed in a vehicle, the battery has to be removed and subjected to measurement when manufacturer's maintenance and inspection are performed.

For secondary batteries such as lithium ion batteries, their deterioration progresses by repetition of charge/discharge and internal resistance increases with a decrease in battery capacity. This makes a change in output of a secondary battery. The degree of deterioration progress of a secondary battery differs depending on usage history of the secondary battery with regard to, inter alia, an environment and a method in which the secondary battery has been used until now. Hence, there is a demand for a technology for accurately estimating a deterioration state of a secondary battery depending on its usage history.

In Patent Literature 1, disclosed is a battery deterioration estimating method for estimating a level of deterioration in capacity of a secondary battery, using, inter alia, an amount of current flowing in the secondary battery.

In Patent Literature 2, disclosed is a residual life diagnosing method for diagnosing residual life of a battery for diagnosis. The battery has been mounted in a motor vehicle that travels with power from an electric motor or prepared to be mounted in the motor vehicle and is comprised of a plurality of modules. This method uses life records such as changing characteristics and discharging characteristics.

Citation List

Patent Literature

    Patent Literature 1: Japanese Patent Publication No. 5466564
    Patent Literature 2: Japanese Patent Publication No. 5338591

Summary of Invention

Technical Problem

The method described in Patent Literature 1 estimates deterioration in capacity of a secondary battery using, inter alia, an amount of current. However, it is difficult to apply this method for estimating battery deterioration at high accuracy, since the internal resistance of a secondary battery changes significantly depending on temperature, SOC, and energizing history among others. Hence, no consideration is taken for an increase in the internal resistance. Hence, there is room for improvement in respect of estimating deterioration, when regarding secondary battery output as important. Besides, as for a deterioration state inside a secondary battery, it is impossible to know how it is.

In the method described in Patent Literature 2, a vehicle type in which a battery is mounted, the battery usage status, and its life records are correlated and stored in a database as life information. In this case, necessary are data of a battery whose life is over, i.e., a battery that has reached the end of its life and data acquired from a predetermined fixed charging sequence or discharging sequence. A decision cannot be made if data is insufficient and data accumulation requires a lot of work-hours.

An object of the present invention resides in determining a deterioration level of a secondary battery module for a short time and accurately and estimating the battery residual life depending on usage history.

Solution to Problem

A method for diagnosing residual life of a secondary battery module according to the present invention comprises the steps of: acquiring charging information including current, voltage, and a charged state of a secondary battery module; obtaining the present capacity and internal resistance of the secondary battery module from the charging information, calculating a deterioration level of the secondary battery module through comparing the capacity and the internal resistance against their initial values, and specifying the deterioration value as an actual measurement value; acquiring output information of the secondary battery module; calculating a predicted value of the deterioration level by a prediction formula, using the output information; comparing the actual measurement value and the predicted value; and calculating residual life, if a difference between the actual measurement value and the predicted value is equal to or less than a predetermined value. If the difference between the actual measurement value and the predicted value is more than the predetermined value, the method is to correct the prediction formula based on the actual measurement value and calculate the predicted value by the corrected prediction formula.

Besides, a system for diagnosing residual life of a secondary battery module according to the present invention comprises a resistance and capacity computing unit, a deterioration estimating unit, and a life calculating unit. The resistance and capacity computing unit acquires charging information including current, voltage, and a charged state of a secondary battery module, obtains the present capacity and internal resistance of the secondary battery module from the charging information, calculates a deterioration level of the secondary battery module through comparing the capacity and the internal resistance against their initial values, and specifies the deterioration value as an actual measurement value. The deterioration estimating unit acquires output information of the secondary battery module, calculates a predicted value of the deterioration level by a prediction formula, using the output information, and compares the actual measurement value and the predicted value. If a difference between the actual measurement value and the predicted value is equal to or less than a predetermined value, the life calculating unit calculates residual life. If the difference between the actual measurement value and the predicted value is more than the predetermined value, the deterioration estimating unit corrects the prediction formula based on the actual measurement value and calculates the predicted value by the corrected prediction formula and the life calculating unit calculates the residual life.

Advantageous Effects of Invention

According to the present invention, it is possible to determine a deterioration level of a secondary battery module for a short time and accurately and estimate the battery residual life depending on usage history.

Brief Description of Drawings

Fig. 1 is an overall structural diagram depicting a device for diagnosing residual life of a secondary battery module according to a first embodiment and equipment that is connected to the device.
Fig. 2 is an overall structural diagram depicting a device for diagnosing residual life of a secondary battery module according to a second embodiment and equipment that is connected to the device.
Fig. 3 is an overall structural diagram depicting an example in which data on a plurality of sets of secondary battery modules and others is managed by one device for diagnosing residual life.
Fig. 4 is a flowchart illustrating an example of a method for diagnosing residual life of a secondary battery module.
Fig. 5 is a graph representing an example of correcting life in the method for diagnosing residual life in Fig. 4.
Fig. 6 is a flowchart illustrating a process that detects abnormality of actual measurement data.
Fig. 7 is a graph representing a relationship of deterioration SOH versus time or travel distance.
Fig. 8 is a schematic structural diagram depicting a concrete example of the present invention.
Fig. 9 is a graph representing examples of a charging curve and an OCV curve.

Fig. 10 is a graph representing a relationship between SOC and resistance.

Fig. 11 is a flowchart illustrating a process of calculating residual life according to the present invention.

Fig. 12 is a graph representing change in current, voltage, and SOC versus battery usage time.

Fig. 13 is a grape representing an effect of the present invention.

Fig. 14 is an overall structural diagram depicting a basic structure of a vehicle's system pertaining to diagnosing residual life of a secondary battery module according to the present invention.

Fig. 15 is one example of a system for diagnosing residual life according to the present invention.

Fig. 16A is a structural diagram depicting an example of diagnosing residual life according to the present invention.

Fig. 16B is a graph representing the deterioration states of respective vehicles.

Fig. 16C is a graph representing an example of temporal change of SOC.

Fig. 17 is a structural diagram depicting an example of a vehicle to which the present invention is applied.

Fig. 18 is a table representing a database example containing operating condition parameters and information for estimating deterioration.

Description of Embodiments

In the following, embodiments of the present invention will be described with reference to the drawings.

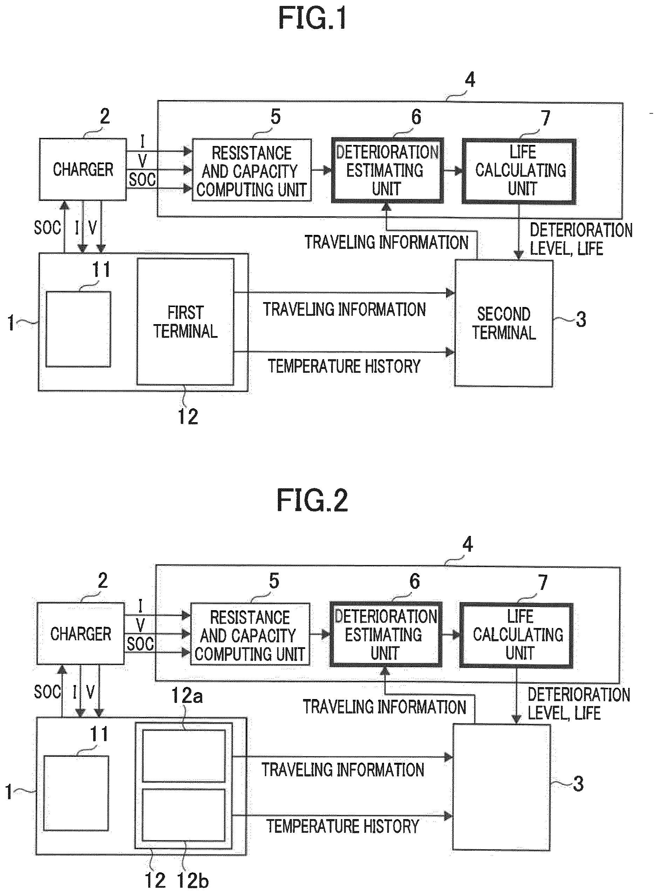

Fig. 1 depicts an overall structure of one embodiment of the invention (a system for diagnosing residual life of a secondary battery module).

In this Figure, a secondary battery module 11 (rechargeable battery module) installed in a vehicle 1 (a battery system) is subject to a residual life diagnosis.

In the vehicle 1, a first terminal 12 is installed that is capable of acquiring traveling information, temperature information, etc. A second terminal 3 is another one than the first terminal 12 and capable of communicating with the first terminal 12 and a server 4 by radio or wire. Additionally, the second terminal 3 may be a smart device carried with a driver or passenger riding in the vehicle 1 or a relay device that is installed in or near a road on which the vehicle 1 travels.

A charger 2 is configured to be capable of transmitting information such as a charging state (State of Charge: SOC), output current I, and output voltage V, which are obtained via a communication protocol within a charging cable when charging is performed, to the server 4 by radio or wired communication. A configuration is made such that traveling information and temperature information acquired by the first terminal 12 is transmitted to the second terminal 3 by radio or wired communication.

The server 4 is a device for diagnosing residual life of a secondary battery module 11 and includes a resistance and capacity computing unit 5, a deterioration estimating unit 6, and a life calculating unit 7. The resistance and capacity computing unit 5, deterioration estimating unit 6, and life calculating unit 7 are arranged to be able to cooperate with each other and share information.

Note that, although description on this drawing uses a term "traveling information", because the drawing is based on a structure of a vehicle such as an electric car, information to be acquired generally includes information on, inter alia, output of a secondary battery module and its stop and, therefore, information on, inter alia, output of a secondary battery module and its stop is collectively referred herein to as "output information". Output information may be that including temperature information. Additionally, the present invention is also applicable to a mobile object such as a traveling robot or flying robot that is powered by a secondary battery, besides a vehicle.

When the vehicle 1 is connected to the charger 2, the secondary battery module 11 is charged. At the same time, the charger 2 acquires, from the vehicle 1, information (charging information) such as SOC, output current I, and output voltage V of secondary batteries constituting the secondary battery module 11. The charger 2 sends acquired charging information to the resistance and capacity computing unit 5. The second terminal 3 sends, inter alia, traveling information to the deterioration estimating unit 6.

The resistance and capacity computing unit 5 computes the present values of capacitance and resistance of the secondary batteries from the acquired information, compares these values with initial values, and calculates a deterioration level. The deterioration estimating unit 6 has a deterioration prediction formula (also simply referred to as a "prediction formula"), converts traveling information sent from the second terminal 3 to parameters for predicting deterioration, and estimates a deterioration level. The deterioration estimating unit 6 refers to actual measurement values acquired by the resistance and capacity computing unit 5 and modifies the deterioration prediction formula. The life calculating unit 7 calculates residual life using standardized values of capacity and resistance based on the life of the vehicle 1. The life calculating unit 7 can send information such as deterioration level and residual life to the second terminal 3.

Note that the "present" capacity and resistance data may be data, for example, acquired a few days ago, but desirably, such data is latest data (real-time data).

In the above description, the server 4 may be configured to include at least the life calculating unit 7 among the resistance and capacity computing unit 5, the deterioration estimating unit 6, and the life calculating unit 7. In that case, the resistance and capacity computing unit 5 and the deterioration estimating unit 6 may be placed in the charger 2. Besides, in a case where the server 4 is configured to include the deterioration estimating unit 6 and the life calculating unit 7 among the resistance and capacity computing unit 5, the deterioration estimating unit 6, and the life calculating unit 7, the resistance and capacity computing unit 5 may be placed in the charger 2.

Fig. 2 depicts an example of modification to the system in Fig. 1.

In this Figure, the first terminal 12 is configured to include a diagnosis terminal 12a utilizing an OBD terminal in the vehicle 1 and a recording terminal 12b to acquire, inter alia, temperature information of respective parts of the vehicle. As mentioned above, multiple terminals may be used. Here, OBD is an abbreviation of On-board diagnostics.

The diagnosis terminal 12a can utilize information over a CAN (Controller Area Network) of the vehicle 1 from the OBD terminal. Through this, acquiring travel distance and speed and acquiring, particularly, battery current and voltage data and battery temperature data make it possible to acquire and analyze a battery charge/discharge pattern that is more detailed. The recording terminal 12b has a function of recording in-car temperature during stop, a time log, etc. Thereby, it is enabled to acquire recorded information and information during driving as well and perform synchronous processing. Therefore, it is enabled to make conversion from more detailed travel history than in the example of Fig. 1 to parameters for estimating deterioration. Hence, condition accuracy increases, a more appropriate deterioration formula can be selected, and estimate accuracy increases.

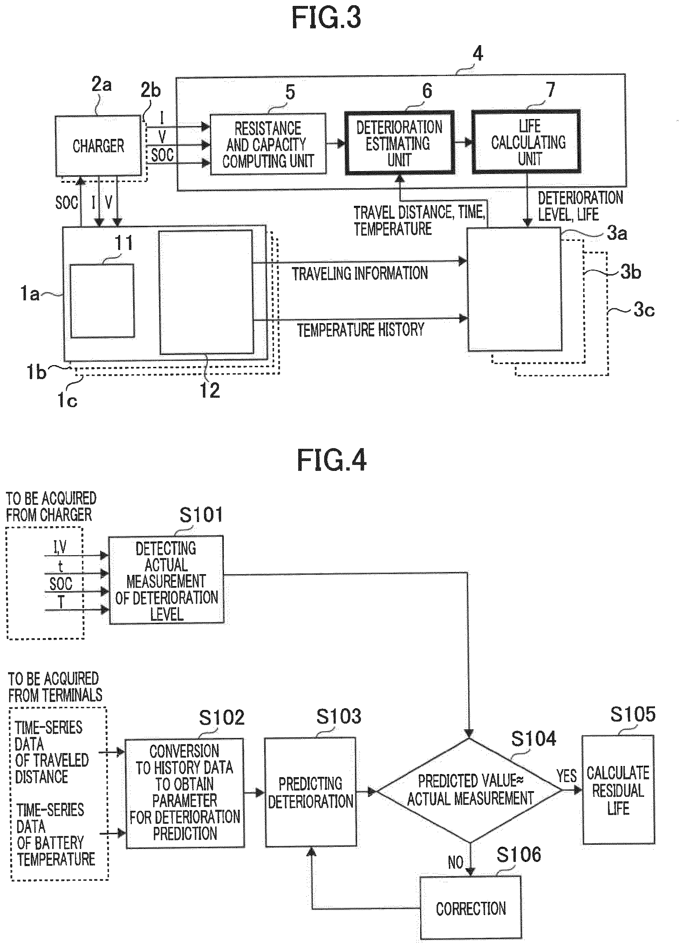

Fig. 3 depicts an example in which one server acquires and accumulates information on multiple vehicles and multiple chargers.

In this Figure, among multiple vehicles 1a, 1b, 1c and multiple chargers 2a, 2b, representative vehicle 1a and charger 2a are drawn with solid lines and other vehicles 1b, 1c and charger 2b are drawn with dashed lines. Also, as for second terminals 3a, 3b, 3c associated with the vehicles 1a, 1b, 1c respectively, a second terminal 3a is drawn with solid lines and other second terminals 3b, 3c are drawn with dashed lines.

This configuration makes it possible to accumulate information on multiple vehicles 1a, 1b, 1c in one server 4. This enables it to enrich a database of deterioration-related data of actual measurements. Then, inter alia, at the start of using a new vehicle, reference to deterioration-related data of the same vehicle type from the database makes it easy to create a deterioration estimate formula that makes reference to initial battery characteristic values and a traveling method and makes it possible to predict battery deterioration and residual life estimates for a short time and more accurately.

Fig. 4 depicts an example of a method for diagnosing residual life of a secondary battery module.

In this Figure, from I, V, SOC, etc. (charging information) acquired from the charger, the method detects or calculates the present capacity and resistance of a battery, compares them with initial values of capacity and resistance, and calculates a deterioration level. A value of this deterioration level is specified as an actual measurement value (S101). On the other hand, from, inter alia, time-series data of distance traveled and time-series data of battery temperature acquired from the first and second terminals, the method extracts, inter alia, history data on traveling time, stop time, and temperature of each battery (S102). When doing so, the method converts data values, as necessary. Then, the method processes acquired data into parameters that are used to predict deterioration and predicts deterioration (S103). As a result, a predicted value of deterioration level is obtained.

The method compares the actual measurement value and the predicted value obtained as above (S104). Then, if a difference between the actual measurement value and the predicted value is equal to or less than a predetermined value, the method proceeds to calculating residual life (S105). Otherwise, if the difference is more than the predetermined value, the method makes a correction (S106). The method uses a predicted value after the correction as the predicted value resulting from step S103 and calculates residual life (S105).

Because the method depicted in this Figure uses constant current data during charging on the vehicle, it is enabled to estimate more exact capacity and resistance than in prior art. Moreover, when the charging is a fast charge, it is possible to calculate a deterioration level as SOHQ or SOHR of a battery in a shorter time. Note that a deterioration level may also be referred to as a "deterioration state".

Here, a deterioration state of a battery is indicated by SOHR computed using internal resistance (which may hereinafter referred to as "resistance" simply) of a battery or SOHQ computed using a fully charged capacity of a battery. SOHR is SOH obtained based on battery internal resistance and represents a rate of increase of battery internal resistance that increases along with deterioration of the battery. SOHR is defined by equation (1) below.

$$\mathrm{SOHR} = 100 \times R_1(\mathrm{SOC}, T)/R_0(\mathrm{SOC}, T) \quad \ldots \quad (1)$$

In the equation, $R_1(\mathrm{SOC}, T)$ denotes internal resistance $[\Omega]$ of a single battery cell 111 in the present state (deteriorated) and $R_0(\mathrm{SOC}, T)$ denotes internal resistance $[\Omega]$ of a new single battery cell 111.

SOHQ computed using capacity is obtained by dividing the present capacity by initial capacity. Although SOHR in the above equation (1) is expressed as a percentage, any expression of a ratio of the present capacity to the initial one may be used, not necessarily limited to a percentage.

By making a correction with an actual measurement value, as above, it is enabled to estimate residual life by exact prediction.

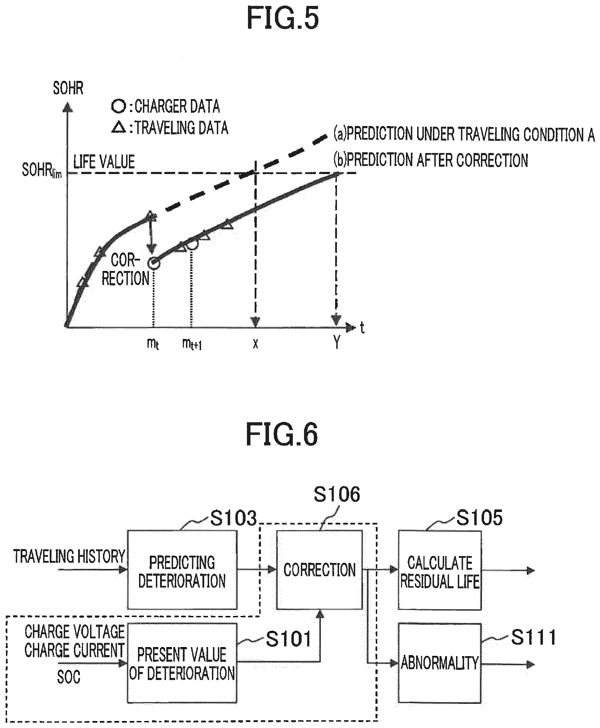

Fig. 5 is a graph representing an example of correcting life in the method for diagnosing residual life in Fig. 4. Time is plotted on the abscissa and deterioration level SOHR is plotted on the ordinate.

In this Figure, a curve (a) drawn with a partially dashed line is based on a predicted value estimated under traveling condition A. In this case, at deterioration level SOHRiim that corresponds to the end of battery life, a value of x is plotted on the abscissa. Hence, an estimated battery life is determined to be x in time.

At a time mt of acquisition of actual measurement value, if an actual measurement value (marked by O in the graph) is lower than a predicted value at mt (marked by Δ in the graph), the prediction formula after the time mt of acquisition of actual measurement value is corrected. Thereby, a curve (b) after correction is obtained. From the curve (b), an estimated battery life is determined to be Y in time.

In this way, by correcting the prediction formula based on an actual measurement value, it is possible to obtain an estimated battery life that is appropriate.

Fig. 6 is a flowchart illustrating a process that detects abnormality of actual measurement data:

As in this Figure, the process compares an actual measurement value (the present value) acquired at S101 based on data from the charger and a predicted value obtained from traveling history at S103. If a difference between the actual measurement value and the predicted value is equal to or less than a predetermined value, the process makes a correction (S106) and proceeds to calculating residual life (S105). However, a case where the difference is so large as not to be correctable, i.e., a case where actual measurement data largely deviates from past history data is judged as abnormal and abnormality is notified (Sill). Abnormality may be notified to the server or the second terminal.

By carrying out an abnormality judgment (S111) at the same time, as noted above, an effect that can be expected is giving a recommendation to perform battery maintenance or change a way of battery usage.

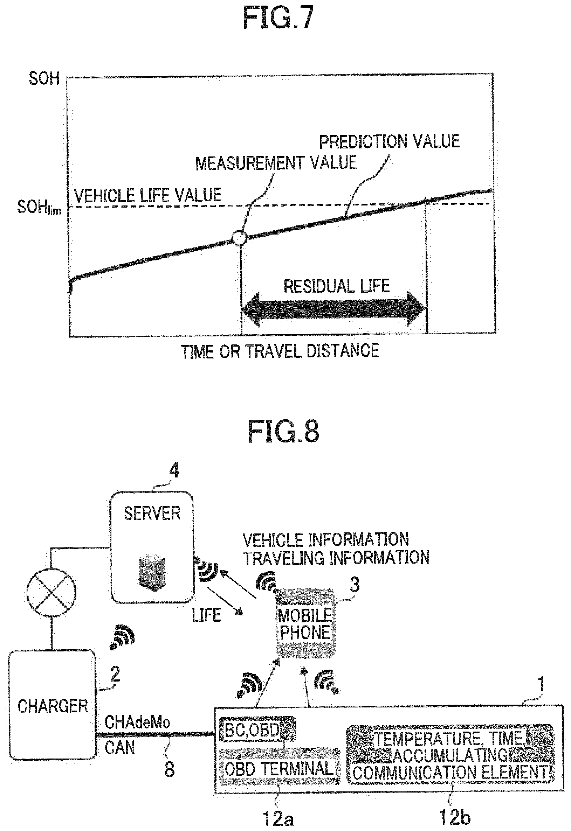

Fig. 7 represents a relationship of deterioration SOH versus time or travel distance.

As in this Figure, output (residual life) from calculating residual life (S105) in Fig. 6 is calculated as a difference between time or travel distance at which a bold solid line of a predicted value curve reaches a value corresponding to a vehicle life value $SOH_{lim}$ and time or travel distance at which the present measurement value (marked by O in the graph) has been acquired and then notified. Thereby, residual life can be indicated in terms of time or travel distance.

Fig. 8 depicts an example of a structure for demonstrating the present invention.

In this Figure, the vehicle 1 is equipped with the diagnosis terminal 12a (OBD terminal) and the recording terminal 12b. In the vehicle 1, provided are a battery control circuit (BC) and an OBD terminal that can acquire information through CAN communication within the vehicle 1. The diagnosis terminal 12a is connected with the OBD terminal and such information is sent to the server 4 by utilizing a communication function of a smart device (the second terminal 3) such as a mobile phone or a smartphone.

The vehicle 1 is connected to the charger 2 via a fast charge cable 8 for charging. The fast charge cable 8 can utilize a communication protocol, e.g., CHAdeMO (a registered trademark). Through this, the charger 2 can acquire data on the vehicle 1 when charging is performed.

Information such as output voltage, output current, and SOC relative to time is sent from the charger 2 to the server 4. The server 4 performs, inter alia, deterioration diagnosis, deterioration prediction, and residual life diagnosis using information (data) received and can display a result of the diagnosis or prediction on the smart device (second terminal 3).

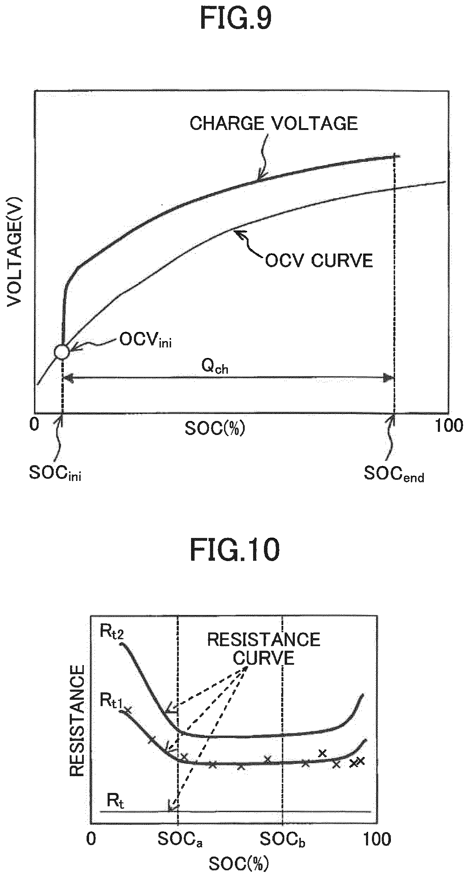

Here, an example of a calculation method for diagnosing a deterioration level to which a battery is deteriorated is presented using a graph in Fig. 9.

Fig. 9 presents an example of an OCV curve. SOC is plotted on the abscissa and voltage is plotted on the ordinate.

From information on the vehicle 1 in Fig. 8, by searching the database for specifications of a battery that is used in the vehicle 1, the OCV curve of the battery is obtained.

By converting an open circuit voltage (OCV) at the start of charging to SOC, a voltage $OCV_{ini}$ that is a starting OCV is obtained.

Through calculating charge voltage versus SOC, as indicated by a charging curve, and by dividing a difference between a charge voltage and OCV at the same SOC by an energizing current value and a resistance value R can be obtained. Especially, immediately after the start of energizing a battery, SOC does not yet change and the battery is less affected by reactive resistance and preferable.

In the case of lithium ion batteries, it is known that the resistance value R calculated as above depends on SOC.

Fig. 10 presents examples of resistance curves of resistance values $R_t$, $R_{t1}$, $R_{t2}$ at time t, t1, t2 from the start of energizing a battery versus SOC. t is approximately 10 ms after the start of energizing. At this stage, parts resistance and electrical resistance are only detected and the resistance value does not change depending on SOC. t1 is one second after and t2 is 5 seconds after the start of energizing. Upon elapse of t1 and t2, an internal resistance value increases and the resistance value changes depending on SOC.

A relationship between R and SOC presented in this Figure can be expressed as a function or a table.

When the battery has been charged from $SOC_a$ to $SOC_b$, a correction is computed through assigning respective resistance values R. When voltage and current at the end of battery charge/discharge are expressed as $V_{last}$ and Iiast and an open circuit voltage detected upon elapse of a given time from the end of battery charge/discharge is expressed as OCV, a resistance value R of a resistance curve is obtained by equation (2) below.

$$R = (|OCV - V_{last}|)/I_{last} \quad \ldots \quad (2)$$

Alternatively, if the current value I of a battery during charge/discharge is constant and when a closed circuit voltage of the battery is expressed as CCV, a resistance value R can also be obtained by equation (3) below.

$$R = (OCV - CCV)/I \quad \ldots \quad (3)$$

Besides, a resistance value R can also obtained from a coefficient A in an approximation formula Ax + C that is calculated from a relationship between multiple currents and the closed circuit voltage of a battery depending on a current value x at a constant SOC. When a constant of C is OCV, the coefficient A is internal resistance DCR.

Furthermore, capacity Q can be obtained by equation (4) below, from the difference between $SOC_{ini}$ as initial SOC and $SOC_{end}$ as terminating SOC, in other words, the range of SOC change and electric charge $Q_{ch}$.

$$Q = Q_{ch}/(SOC_{end} - SOC_{ini}) \times 100 \quad \ldots \quad (4)$$

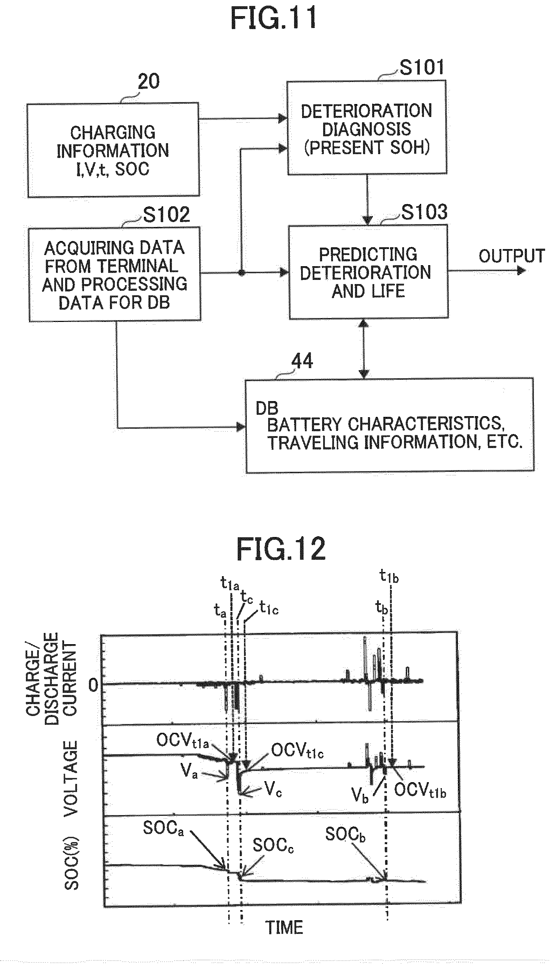

An overview of how the present invention is implemented is further described with Fig. 11.

Data is acquired from the first terminal 12 and the second terminal 3 depicted in Fig. 1 and processed to be accumulated in the database 44 (S102). Subsequently, processed data is accumulated in the database 44 as battery characteristics, traveling information, etc. On the other hand, the detection unit 20 acquires charging information such as current, voltage, time, and SOC and processes them. As input, using thus processed data and data such as temperature obtained by processing traveling information and others accumulated in the database 44 at S102, deterioration diagnosis is performed and the present deterioration level SOH is calculated (S101). Then, by utilizing traveling information and referring to the present deterioration level SOH and the database 44, deterioration and a life value are predicted and output (S103).

At S102, optional analysis processing such as usage history analysis processing may be performed using data such as voltage, current, and time accumulated through a data accumulating and selecting process by the detection unit 20. Thereby, parameters of operation with respect to batteries (operating parameters) are extracted.

Fig. 12 presents an example of change in current, voltage, and SOC versus battery usage time.

When extracting operating parameters, the values of current, voltage, and SOC at any given time, as in this Figure, are used. Then, these values are processed.

A process of predicting deterioration S103 in Fig. 11 predicts deterioration in the capacity and resistance of a battery, based on extracted operating parameters and the present deterioration level SOH obtained by deterioration diagnosis. Here, the process predicts how the resistance and capacity of a battery change from now on, using a database regarding a relationship between prestored operating parameters and battery deterioration progress.

To build a prediction model with high accuracy for predicting battery deterioration, it is necessary that the data amount is much. In a prior art example in which a deterioration prediction formula cannot be updated, it was required to perform a great number of battery tests until establishing and implementing a deterioration prediction formula.

In the present invention, the database is updated successively and a deterioration prediction formula is also updated. Therefore, even after a prediction formula is created and implemented with a certain amount of data, actual measurement data increases and it is possible to update the deterioration prediction formula. Hence, as the amount of measurement data increases, an error can be decreased.

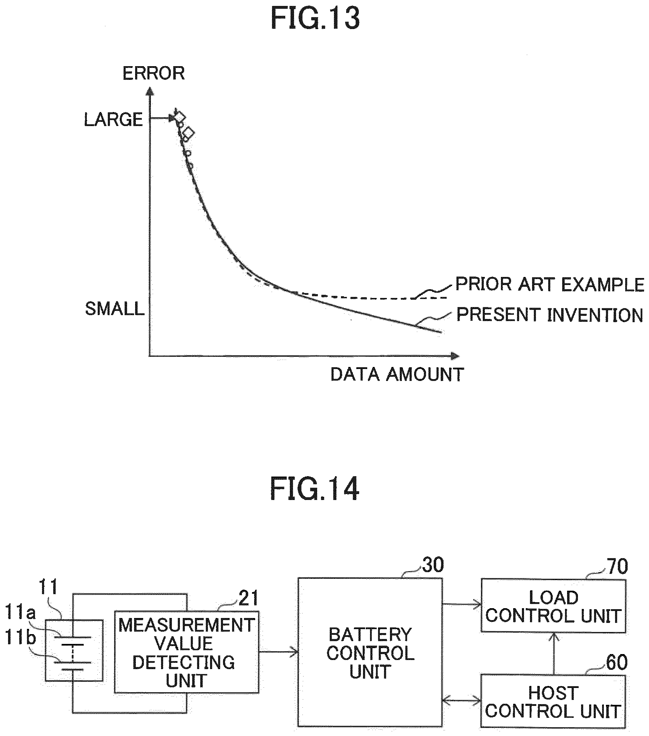

Fig. 13 represents an effect of the present invention in comparison with a prior art example. Data amount is plotted on the abscissa and error is plotted on the ordinate. A solid line curve is of the present invention and a dashed line curve is of the prior art example.

As in this Figure, in the case of the prior art, the error decreases gradually in a region where the data amount is smaller, but its decrease stops, as the data amount continues to increase. By contrast, in the case of the present invention, the error continues to decreases even with an increase in the data amount.

As seen from the above, because a deterioration prediction formula is updated even after being implemented in the present invention, it is possible to decrease man-hours for building a model until its implementation. In other words, it is possible to reduce man-hours for battery deterioration tests for building a battery deterioration estimate formula and it is enabled to make a residual life diagnosis at high certainty in a short time.

Fig. 14 depicts a basic structure of a vehicle's battery system pertaining to diagnosing residual life of a secondary battery module according to the present invention.

In this Figure, the system structure includes a secondary battery module 11 (rechargeable battery module) for use in a vehicle and a measurement value detecting unit 21 installed within the vehicle. The secondary battery module 11 is comprised of a plurality of single batteries 11a, 11b having positive and negative electrodes and connected in series. The secondary battery module 11 is connected to a load, not depicted, and supplies power to the load.

Besides, a battery control unit 30, a host control unit 60, and a load control unit 70 are also components of the system.

The present system controls the secondary battery module 11 through the battery control unit 30, host control unit 60, and load control unit 70.

The measurement value detecting unit 21 detects a variety of information (data) regarding the state of the secondary battery module 11. It detects, e.g., the following data on the secondary battery module 11: total current, total voltage, ambient temperature, maximum temperature, average temperature, minimum temperature, temperature and voltage of each single battery cell 11a, 11b, etc. Data detected by the measurement value detecting unit 21 is input to the battery control unit 30. Note that it is desirable to also detect, inter alia, the type or model of each single battery cell 11a, 11b, in other words, the individual attributes of the signal battery cells 11a, 11b.

The battery control unit 30 calculates the present charged state (SOC) of the secondary battery module 11 based on data input from the measurement value detecting unit 21 and, besides, performs processing such as detecting an abnormal state, calculating power that can be input and output, and generating a temperature control command. Resulting information acquired by the host control unit 60 is output to the load control unit 70.

The load control unit 70 performs load control based on a control command input from the host control unit 60 and information input from the battery control unit 30.

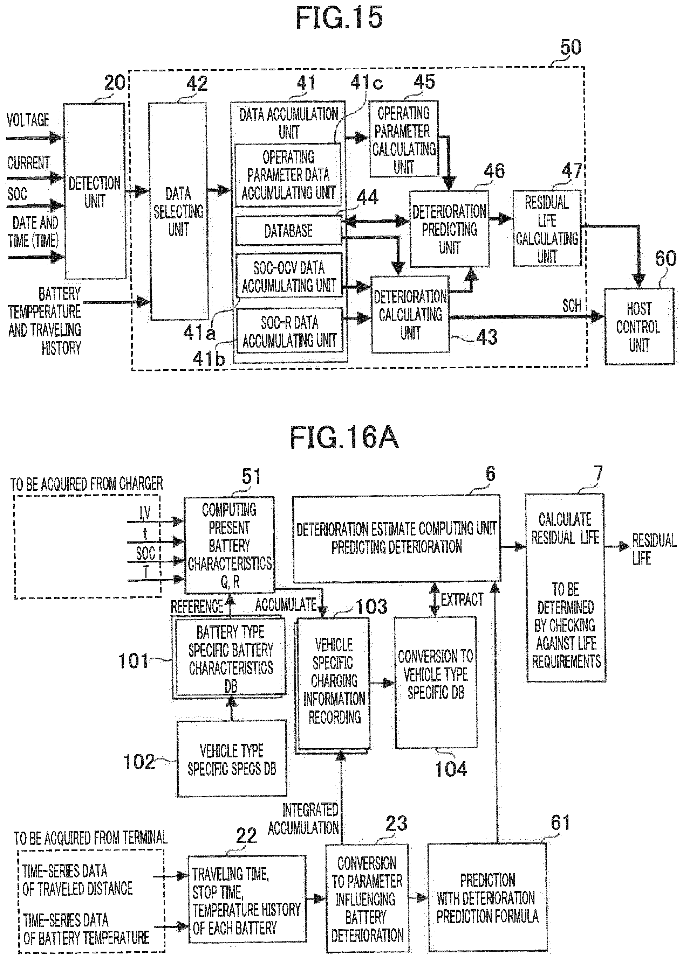

Fig. 15 is one example of a system for diagnosing residual life according to the present invention.

In this Figure, a residual life diagnosing unit 50 includes respective functional blocks below: a data accumulation unit 41, a data selecting unit 42, a deterioration calculating unit 43, an operating parameter calculating unit 45, a deterioration predicting unit 46 (a deterioration state estimating unit), and a residual life calculating unit 47. The residual life diagnosing unit 50 can implement the respective functions of these functional blocks by executing prestored programs by the CPU.

The detection unit 20 detects data such as battery voltage, current, and temperature with time information such as date and time and outputs such data to the residual life diagnosing unit 50. At the same time, SOC information that was notified to the charger and computed is also input to the residual life diagnosing unit 50. In the residual life diagnosing unit 50, the data selecting unit 42 selects information and data that meet preset conditions out of output information from the vehicle including data related to battery temperature and traveling history acquired by the measurement value detecting unit 21 (Fig. 14) within the vehicle and data output from the detection unit 20 and outputs those selected to the data accumulation unit 41. Note that measurement values of battery temperature and traveling history measured by the measurement value detecting unit 21 in Fig. 14 are acquired via the OBD terminal, the first terminal 12, and the second terminal 3.

The data accumulation unit 41 includes an SOC-OCV data accumulating unit 41a, an SOC-R data accumulating unit 41b (an SOC-resistance data accumulating unit), an operating parameter data accumulating unit 41c, and a database 44.

The data selecting unit 42 acquires data of open circuit voltage versus SOC meeting the conditions for a certain period or every certain number of times and accumulates that data into the SOC-OCV data accumulating unit 41a. Likewise, this unit acquires data of resistance versus SOC and accumulates that data into the SOC-R data accumulating unit 41b. Based on data output from the measurement value detecting unit 21 in the vehicle in Fig. 14, this unit acquires data such as current, energizing time, and SOC change for a short time, e.g., a few minutes, as usage history data depending on usage time of the secondary battery module 11 and accumulates that data into the operating parameter data accumulating unit 41c.

Accumulated data is analyzed by the operating parameter calculating unit 45.

The database 44 is provided with various sorts of data to be used for estimating deterioration. The data includes, e.g., a prediction formula for estimating deterioration, initial values of parameters, changed values of parameters, etc. Using data in the SOC-OCV data accumulating unit 41a and the SOC-R data accumulating unit 41b, the database 44 computes capacity and resistance indicative of an internal state and detects deterioration. Note that battery initial data is also stored in advance in the SOC-OCV data accumulating unit 41a and the SOC-R data accumulating unit 41b. The deterioration calculating unit 43 estimates the present deterioration state and outputs a result to the host control unit 60 and the deterioration predicting unit 46. Parameters calculated by the operating parameter calculating unit 45 are used by the deterioration predicting unit 46 to predict time-series deterioration. Moreover, the residual life calculating unit 47 calculates predicted life or residual life using the database 44 and outputs a result to the host control unit 60.

Here, operation of the operating parameter calculating unit 45 is described in detail.

From data selected by the data selecting unit 42, the operating parameter calculating unit 45 calculates various operating parameters with regard to operating conditions of the secondary battery module 11 based on usage history data accumulated in the operating parameter data accumulating unit 41c within the data accumulation unit 41. The operating parameters of the secondary battery module 11 are, e.g., as follows: during operation, an operating central SOC, an operating voltage range, an operating upper limit voltage, an operating lower limit voltage, average current, maximum and minimum currents, battery temperature, ambient temperature, a heat generating factor, an effective current, operating average electric charge, charging capacity, discharging capacity, a range of SOC change, an energizing polarity ratio per unit time, a stop time ratio per unit time, etc. Note that the operating parameters are not limited to those mentioned above. The operating parameter calculating unit 45 can use parameters that can be derived from various operating conditions as the operating parameters of the secondary battery module 11.

Besides, the data selecting unit 42 selects a predetermined range of data detected by the measurement value detecting unit 21 as data to be accumulated into the data accumulation unit 41 and for calculating parameters regarding usage of the secondary battery module 11. The data selecting unit 42 can make data selection, for example, by a method that is described below.

Note that, in the following description, a data selection method by the data selecting unit 42 is described with the example of detected data on the vehicle presented in Fig. 12.

As noted previously, Fig. 12 represents change in current, voltage, and SOC versus usage time of the secondary battery module 11 as one example of data that is detected by the measurement value detecting unit 21.

In the measurement data in Fig. 12, the data selecting unit 42 first identifies a time $t_a$ immediately before the current changes from predetermined $I_j$ to 0 and the secondary battery module 11 is placed in an open circuit state. This unit acquires a voltage $V_a$ and charged state $SOC_a$ at the time $t_a$, as the voltage and charged state at the end of charge/discharge of the secondary battery module 11 respectively.

Then, the data selecting unit 42 identifies a time $t_{1a}$ upon elapse of a certain time after the secondary battery module 11 is placed in the open circuit state and acquires a voltage $OCV_{1a}$ at the time $t_{1a}$ as the open circuit voltage of the secondary battery module 11. Likewise, also at times $t_b$ and $t_{b1}$ and times $t_c$ and $t_{c1}$, this unit acquires voltages Vb and Vc at the end of charge/discharge of the secondary battery module 11, charged state $SOC_b$ and $SOC_c$ at the end of charge/discharge, and open circuit voltages $OCV_{1b}$ and $OCV_{1c}$, respectively. At the same time, this unit records the number of times (time at which) each SOC has been detected and discharge current at the time; thereby, a cumulative discharge amount Q can be acquired per SOC. Using this value, by summing the values of the cumulative discharge amount Q for all acquired SOC values, a total discharge amount Qdt (Ah) used for a period of state decision can be calculated. For a charge current as well, by accumulating it in the same way, a total charge amount Qct (Ah) can be acquired and a total usage capacity Qt can be obtained.

Furthermore, using the number of times (time at which) SOC has been detected, by dividing cumulative discharging capacity $\Sigma Q_{dm}$ for each SOC by the number of times $N_{im}$ SOC has been detected, average energizing current $I_{ave}$ can be calculated per SOC and a feature of battery energizing history can be extracted.

When SOC is constant during a predetermined time $t_{p2}$, the data selecting unit acquires the SOC and a voltage upon elapse of $t_{p2}$. Besides, accumulating data regarding battery temperature and ambient temperature is performed in the same manner and such data can be accumulated as usage history data.

From current values during energizing accumulated in this way as usage history data, additionally, electric charge changed during energizing and the energizing time can also be acquired. The data selecting unit 42 selects a variety of data thus acquired including a plurality of sets of current, voltage, SOC, time instants, time, electric charge, etc. as data for predicting deterioration.

The host control unit 60 can give an optimal output command to the secondary battery module 11 based on a predicted life value and a deterioration state notified from the residual life calculating unit 47 via the second terminal 3. For example, to make a downward change in the operating central SOC of the secondary battery module 11, this unit performs control to cause the secondary battery module 11 to discharge a certain quantity of power until the voltage of the secondary battery module 11. has reached a target voltage. Alternatively, this unit changes the balance between charge and discharge currents; it controls the current of the secondary battery module 11 so that an absolute value of cumulative discharge amount will become larger than an absolute value of cumulative charge amount within a certain period and makes an adjustment to decrease the operating central SOC to the extent without affecting the system operation significantly.

Thereby, the deterioration rate of the secondary battery module 11 is restrained at lower SOC and, therefore, it is achievable to extend the life of the secondary battery module 11. Alternatively, when a maximum value of energizing current is significantly involved with the deterioration of the secondary battery module 11, it is possible to control the life of the secondary battery module 11 by restricting the current value and changing the ratio between energizing time and stop time.

Moreover, from a predicted life value and data on operation conditions notified from the residual life calculating unit 47 via the second terminal 3 and/or the first terminal 12, the host control unit 60 may execute a revenue calculation of the battery system and other calculations in terms of energy efficiency, fuel consumption, etc. and may decide whether to change the operating conditions of the secondary battery module 11.

The operating parameter calculating unit 45 in Fig. 15 is capable of analyzing a wide variety of operation parameters such as, e.g., a starting voltage $V_{ini}$, a terminating voltage Viast, a maximum voltage $V_{max}$, a minimum voltage $V_{min}$, cell temperature $T_c$, ambient temperature $T_a$, charging capacity $Q_c$, discharging capacity $Q_d$, change in electric charge per unit time $\Delta Q$, maximum current $I_{max}$, minimum current $I_{min}$, average current $I_{ave}$, effective current $I_e$, operating central voltage $V_{center}$, a ratio of time of staying in each voltage domain $R_{atet}$, an energizing polarity ratio per unit time tp, an energizing time ratio ts, a stop time ratio tr, upper and lower limit SOC ($SOC_{max}$, $SOC_{min}$), a range of SOC change $\Delta SOC$, and energizing time $t_{total}$. Note that the energizing polarity ratio ts is an index of what number of times charging and discharging polarity has changed within a certain energizing time.

As presented in Fig. 12, SOC also changes with a change in the charge/discharge current in the case of the secondary battery module 11 (Fig. 1 among others). While SOC changes, a maximum value of SOC is recorded as maximum SOC and a minimum value of SOC is recorded as minimum SOC; thereby, the range of SOC change $\Delta SOC$ can be obtained from a difference between these values. Also, change in electric charge per unit time $\Delta Q$ can, for example, be obtained by extracting from a current waveform, electric charge $\Delta Q_c$ for a section where charging continues and electric charge $\Delta Q_d$ for a section where discharging continues, integrating these values within unit time, and dividing a result by an average value. Besides, using, inter alia, an integrated value $I^2t$ of a heat generating factor, this value being defined as an index of heat generation, and an amount of change in battery temperature $\Delta T$, it is possible to perform analysis of operating parameters. Note that the number of pieces of data to be used for analysis of operating parameters can be determined optionally.

In Fig. 15, the operating parameter calculating unit 45 analyzes operating parameters acquired during a period ranging from a few hours to dozens of days depending on an accumulation period of data accumulated in the data accumulation unit 41 and approximates these parameters into patterns corresponding to operating states. Moreover, a result of deterioration calculation and operating parameters used for the calculation may be accumulated in time sequence as a third history set and the conditions and change in capacity and resistance in conjunction with a change in the operating method may be recorded. This provides an effect that abnormality of the secondary battery module 11 can be found easily.

Besides, a data recording unit may be provided within the vehicle to record date and time when the vehicle is keyed on and keyed off and OCV; this makes an increase in the points for acquiring SOC-OCV. Moreover, even when and after the vehicle is keyed off, based on a signal that is input externally using a timer such as an external clock, usage history data of the secondary battery module 11 may be acquired every predetermined time and accumulated in the first terminal 12 or the second terminal 3. For example, voltage of the secondary battery module 11 can be detected by the measurement value detecting unit 21 using the power of the secondary battery module 11 itself and, from a result of the detection, OCV data can be acquired and accumulated. When thus acquiring data, by acquiring data at a suitable elapsed time after the vehicle is keyed off and then turning the power off, it is possible to acquire stable OCV values as usage history data of the secondary battery module 11 in addition to preventing the secondary battery module 11 from being consumed. By executing data analysis using thus acquired stable OCV values, it is enabled to further increase the accuracy of estimating deterioration and use the secondary battery module 11 effectively.

Besides, when temperature data regarding battery usage is not output via the OBD terminal in the vehicle, air temperature and battery temperature when the vehicle travels and when the vehicle stops are recorded with the first terminal 12 or the second terminal 3 and used as temperature history of the battery. Thereby, the accuracy of detecting deterioration increases and the accuracy of estimating deterioration and estimating residual life also increases, as compared with a case where there is no temperature history of the battery. Hence, it is enabled to use the secondary battery module effectively.

(A flow of estimating a deterioration state)

Fig. 16A is a structural diagram depicting an example of diagnosing residual life according to the present invention.

A resistance and capacitance calculating unit 51 depicted in this Figure acquires at least two or more of current, voltage, and SOC data changing over time from the charger, refers to a vehicle type specific specs database 102 and a battery type specific battery characteristics database 101 with which it has been provided in advance, and calculates the present capacity Q and resistance R. Then, this unit computes deterioration level SOH relative to initial values. The unit accumulates a result of the computing into an information recording unit 103 as a vehicle specific record.

Also, a traveling information acquiring unit 22 extracts traveling time, stop time, and temperature history of each battery (temperature information) from time-series data of distance traveled and time-series data of battery temperature acquired from the first and second terminals. Then, a traveling information to parameter converting unit 23 further converts these pieces of data to parameters influencing battery deterioration. The information recording unit 103 also records and accumulates data obtained by the traveling information to parameter converting unit 23 together with data acquired by the resistance and capacitance calculating unit 51. Data (parameters) obtained by the traveling information to parameter converting unit 23 is used for estimating deterioration over time by a deterioration prediction computing unit 61 using a deterioration prediction formula.

On the other hand, data accumulated as vehicle specific records in the information recording unit 103 is converted into a vehicle type specific database 104 (a database per vehicle type). Data in the vehicle type specific database 104 is used for creating an estimate formula using the present deterioration level.

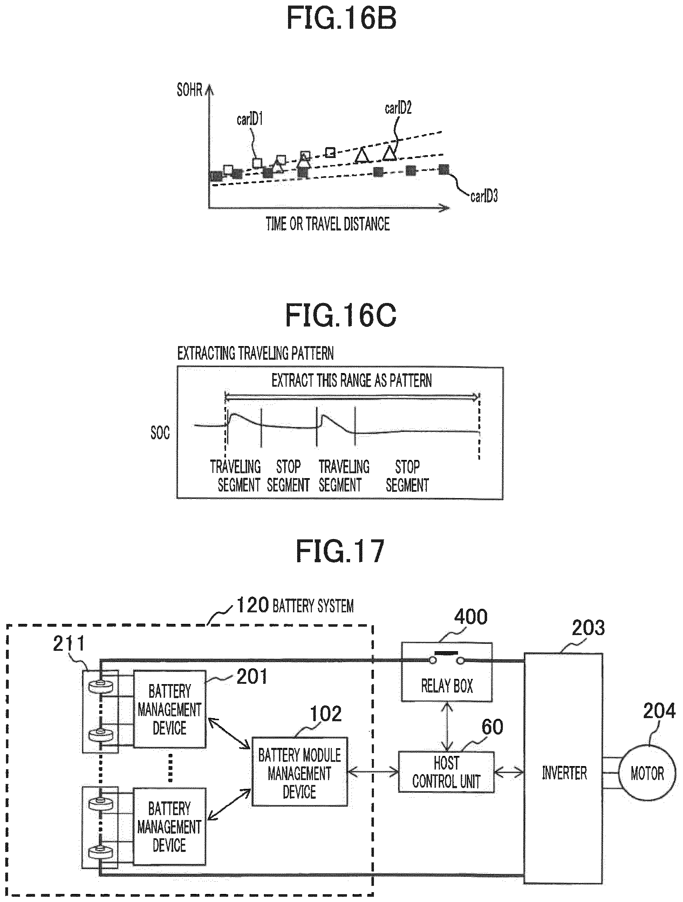

Fig. 16B is a graph representing the deterioration states of respective vehicles.

As in this Figure, a deterioration formula is created and used with respect to each ID of a vehicle.

The deterioration estimating unit 6 compares a deterioration prediction formula created from operating parameters and a deterioration formula created using the vehicle type specific database 104. If there is a divergence from a value estimated by the deterioration prediction computing unit 61 using a prediction formula, a correction is made. The life calculating unit 7 calculates residual life in terms of time or travelable distance through checking against life requirements. In this way, it is enabled to further increase the accuracy of estimating deterioration and utilize the battery properly.

Fig. 16C is a graph representing an example of temporal change of SOC.

As presented in this Figure, a section where SOC changes significantly is specified as a traveling segment (a battery operating segment) and a section where SOC hardly changes is specified as a stop segment. A series of the traveling and stop segments is extracted as a certain pattern.

Vehicle traveling information is converted to, e.g., parameters mentioned below.

To create information on temperature and voltage for each of usage time and save time of a battery as history, at least two pieces of information are processed from among traveling time, distance traveled, average speed, average current, a ratio between stop time and usage time, etc. Parameters may include a parameter that corresponds to an index of battery deterioration, other than those mentioned here. Concrete examples of parameters are as follows: traveling time, (distance traveled/$\Sigma$ traveling time) = average speed, (charging capacity/traveling time) = average current, average SOC, voltage presence time of each battery, (traveling time/total time), (stop time/total time), (traveling time/stop time), etc. Taking SOC, current, and voltage data as an example, data acquired continuously is divided into narrow and suitable width slots and a feature waveform is extracted.

Fig. 16C is an example illustrating a part of change of SOC when the battery is used.

When SOC change is repeated in units of a waveform of SOC change as presented in this Figure, the waveform is extracted as a feature traveling pattern. Deterioration can be predicted from a time-series change in battery characteristics with this feature traveling pattern appearing.

Fig. 17 is a structural diagram depicting an example of a vehicle to which the present invention is applied.

In this Figure, the vehicle includes a battery system 120, an inverter 203, and a motor 204. A relay box 400 is placed between the battery system 120 and the inverter 203.

The battery system 120 includes a battery management device 201, a battery module management device 202, and batteries 211. The battery module management device 202 is connected to the host control unit 60. The host control unit 60 is connected with the inverter 203 and the relay box 400.

Data that is communicated between and used by the battery module management device 202 and the host control unit 60 is acquired by the server 4 in Fig. 1 as a part of traveling history (traveling information).

The batteries 211 may be those comprised of single battery cells connected in series or parallel. In this case, it is desirable that the battery management device 201 is configured to be able to detect data on each of the single battery cells. Note that the batteries 211 or single battery cells are referred to as "battery elements" in the present specification. Also, "residual life" is a value of residual life of a secondary battery module or each of the battery elements. Furthermore, a "deterioration level of a secondary battery module" is a concept including a deterioration level of each of the battery elements as well.

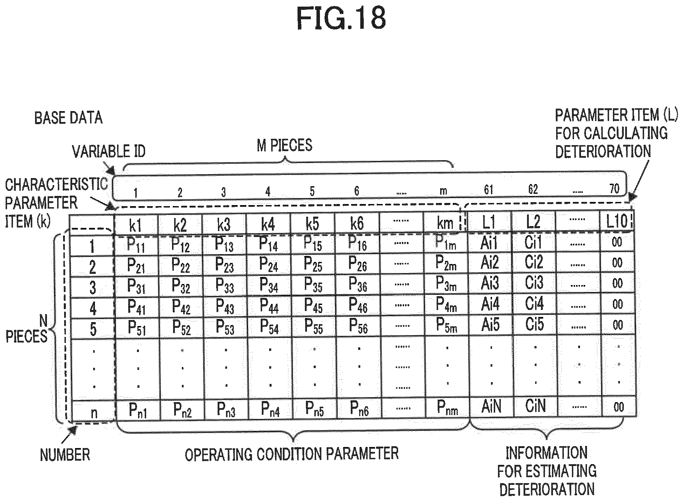

Fig. 18 is a table representing a database example containing operating condition parameters and information for estimating deterioration. That is, this table illustrates an example of charging records for each individual vehicle accumulated in the information recording unit 103 in Fig. 16A; i.e., an example of charging records for each of N vehicles. Note that this table can also be seen as an example of charging records for each of N battery elements comprised in a secondary battery model installed in one vehicle.

A part, operating condition parameters and a part, information for estimating deterioration are seen in the table in Fig. 18.

The operating condition parameters are items from k1 to km and include at least one or more of conditions as follows: e.g., a load current waveform, used battery capacity ($\triangle$SOC), a central value of operating voltage of the secondary battery module 11 (central SOC), starting voltage ($V_{ini}$), starting SOC, charge current, discharge current, cycle time, stop time, energizing time, long time stop, the amount of heat generation, battery temperature, ambient temperature, etc. The parameters may also include saving conditions such as battery temperature and saved voltage and information such as travel distance and speed.

The part, information for estimating deterioration consists of items from L1 to L10 and includes parameters for calculating deterioration and information such as measured resistance R, capacity Q, and SOH.

As described hereinbefore, by detecting deterioration successively and storing data relevant to the deterioration in time sequence in a database and by executing calculation to predict deterioration using the database, it is enabled to obtain residual life more accurately from a small amount of data.

As above, according to the present invention, even without preparing special discharging means, it is possible to properly detect information regarding a deterioration state of a secondary battery module, acquire, inter alia, capacity and resistance of the secondary battery module, indicative of an internal state of the secondary battery module, and calculate system's residual life accurately. Hence, through feedback to an operating method, it is possible to provide a battery system whose life can be controlled, in which a secondary battery module can be used to the maximum within a predetermined period.

List of Reference Signs

1, 1a, 1b, 1c: vehicle, 2, 2a, 2b: charger, 3, 3a, 3b, 3c: second terminal, 4: server, 5: resistance and capacity computing unit, 6: deterioration estimating unit, 7: life calculating unit, 8: fast charge cable, 11: secondary battery module, 12: first terminal, 12a: diagnosis terminal, 12b: recording terminal, 20: detection unit, measurement value detecting unit, 22: traveling information acquiring unit, 23: traveling information to parameter converting unit, 30: battery control unit, 41: data accumulation unit, 41a: SOC-OCV data accumulating unit, 41b: SOC-R data accumulating unit, 41c: operating parameter data accumulating unit, 42: data selecting unit, 43: deterioration calculating unit, 44: database, 45: operating parameter calculating unit, 46: deterioration predicting unit, 47: residual life calculating unit, 50: residual life diagnosing unit, 51: resistance and capacitance calculating unit, 60: host control unit, 61: deterioration prediction computing unit, 70: load control unit, 101: battery characteristics database, 102: vehicle type specific specs database, 103: information recording unit, 104: vehicle type specific database, 120: battery system, 201: battery management device, 202: battery module management device, 203: inverter, 204: motor, 211: batteries, 400: relay box.

**Claims**

1. A method for diagnosing residual life of a secondary battery module (11), the method comprising the steps of:

   acquiring charging information including current, voltage, and a charged state ($SOC_b$, $SOC_c$) of a secondary battery module (11);
   obtaining a present capacity (Q) and an internal resistance (DCR) of the secondary battery module (11) from the charging information, calculating a deterioration level (SOH, SOHQ, SOHR) of the secondary battery module (11) through comparing the capacity and the internal resistance (DCR) against their initial values, and specifying the deterioration value as an actual measurement value;
   acquiring output information of the secondary battery module (11) ;
   calculating a predicted value of the deterioration level (SOH, SOHQ, SOHR) by a prediction formula, using the output information;
   the method being **characterized in that** it also comprises the steps of:

   comparing the actual measurement value and the predicted value; and
   calculating residual life, if a difference between the actual measurement value and the predicted value is equal to or less than a predetermined value,
   wherein, if the difference between the actual measurement value and the predicted value is more than the predetermined value, the method is to correct the prediction formula based on the actual measurement value and calculate the predicted value by the corrected prediction formula.

2. The method for diagnosing residual life of a secondary battery module (11) according to claim 1, wherein the charging information includes current, voltage, and a charged state ($SOC_b$, $SOC_c$) of each of battery elements constituting the secondary battery module (11).

3. The method for diagnosing residual life of a secondary battery module (11) according to claim 2, wherein the charging information includes individual attributes of the battery elements.

4. The method for diagnosing residual life of a secondary battery module (11) according to claim 2, wherein the residual life includes a value of residual life of each of the battery elements.

5. The method for diagnosing residual life of a secondary battery module (11) according to claim 1, wherein the output information includes temperature information.

6. A system for diagnosing residual life of a secondary battery module (11),
   the system comprising a life calculating unit (7) and configured to perform the following:

   acquiring charging information including current, voltage, and a charged state ($SOC_b$, $SOC_c$) of a secondary battery module (11);
   obtaining a present capacity (Q) and an internal resistance (DCR) of the secondary battery module (11) from the charging information, calculating a deterioration level (SOH, SOHQ, SOHR) of the secondary battery module (11) through comparing the capacity and the internal resistance (DCR) against their initial values, and obtaining a first result in which the deterioration value is specified as an actual measurement value;
   acquiring output information of the secondary battery module (11) ;
   calculating a predicted value of the deterioration level (SOH, SOHQ, SOHR) by a prediction formula, using the output information; and
   obtaining a second result of comparing the actual measurement value and the predicted value,
   wherein:

   if a difference between the actual measurement value and the predicted value is equal to or less than a predetermined value, the life calculating unit (7) calculates residual life;
   if the difference between the actual measurement value and the predicted value is more than the predetermined value, the system corrects the prediction formula based on the actual measurement value and calculates the predicted value by the corrected prediction formula; and
   the life calculating unit (7) calculates the residual life.

7. The system for diagnosing residual life of a secondary battery module (11) according to claim 6, further comprising a deterioration estimating unit (6),
   wherein the deterioration estimating unit (6) obtains the first result and sends the second result to the life calculating unit (7).

8. The system for diagnosing residual life of a secondary battery module (11) according to claim 7, further comprising a resistance and capacity computing unit (5),
   wherein the resistance and capacity computing unit (5) sends the first result to the deterioration estimating unit (6).

9. The system for diagnosing residual life of a secondary battery module (11) according to claim 6, wherein the charging information includes current, voltage, and a charged state ($SOC_b$, $SOC_c$) of each of battery elements constituting the secondary battery module (11).

10. The system for diagnosing residual life of a secondary battery module (11) according to claim 9, wherein the charging information includes individual attributes of the battery elements.

11. The system for diagnosing residual life of a secondary battery module (11) according to claim 6, wherein the secondary battery module (11) is a power source of a mobile object and
    the system acquires the output information from a second terminal (3) that is another one than the first terminal (12) that is installed in the mobile object.

12. The system for diagnosing residual life of a secondary battery module (11) according to claim 11 wherein:

    the first terminal (12) comprises a plurality of terminals; and
    the output information is sent from the plurality of terminals to the second terminal (3).

13. The system for diagnosing residual life of a secondary battery module (11) according to claim 6, wherein the system acquires the charging information from a charger (2).

14. The system for diagnosing residual life of a secondary battery module (11) according to claim 6, further comprising a database (44) capable of accumulating the charging information and the output information on a plurality of ones of the secondary battery module (11) .

15. The system for diagnosing residual life of a secondary battery module (11) according to claim 6, wherein the output information includes temperature information.

**Patentansprüche**

1. Verfahren zum Diagnostizieren der Restlebensdauer eines Sekundärbatteriemoduls (11), wobei das Verfahren die folgenden Schritte umfasst:

Erfassen von Ladeinformationen, die Strom, Spannung und Ladezustand ($SOC_b$, $SOC_c$) enthalten, eines Sekundärbatteriemoduls (11);
Erhalten einer gegenwärtigen Kapazität (Q) und eines Innenwiderstands (DCR) des Sekundärbatteriemoduls (11) aus den Ladeinformationen, Berechnen eines Verschlechterungsgrads (SOH, SOHQ, SOHR) des Sekundärbatteriemoduls (11) durch Vergleichen der Kapazität und des Innenwiderstands (DCR) mit ihren Anfangswerten und Spezifizieren des Verschlechterungswerts als einen tatsächlichen Messwert;
Erfassen von Ausgabeinformationen des Sekundärbatteriemoduls (11);
Berechnen eines Vorhersagewerts des Verschlechterungsgrads (SOH, SOHQ, SOHR) durch eine Vorhersageformel unter Verwendung der Ausgabeinformationen;
wobei das Verfahren **dadurch gekennzeichnet ist, dass** es auch die folgenden Schritte umfasst:

Vergleichen des tatsächlichen Messwerts mit dem Vorhersagewert; und
Berechnen der Restlebensdauer, falls eine Differenz zwischen dem tatsächlichen Messwert und dem Vorhersagewert gleich oder kleiner als ein vorgegebener Wert ist,
wobei dann, wenn die Differenz zwischen dem tatsächlichen Messwert und dem Vorhersagewert größer als der vorgegebene Wert ist, das Verfahren darin besteht, die Vorhersageformel basierend auf dem tatsächlichen Messwert zu korrigieren und den Vorhersagewert durch die korrigierte Vorhersageformel zu berechnen.

2. Verfahren zum Diagnostizieren der Restlebensdauer eines Sekundärbatteriemoduls (11) nach Anspruch 1, wobei die Ladeinformationen Strom, Spannung und einen Ladezustand ($SOC_b$, $SOC_c$) jedes der das Sekundärbatteriemodul (11) bildenden Batterieelemente enthalten.

3. Verfahren zum Diagnostizieren der Restlebensdauer eines Sekundärbatteriemoduls (11) nach Anspruch 2, wobei die Ladeinformationen individuelle Attribute der Batterieelemente enthalten.

4. Verfahren zum Diagnostizieren der Restlebensdauer eines Sekundärbatteriemoduls (11) nach Anspruch 2, wobei die Restlebensdauer einen Wert der Restlebensdauer jedes der Batterieelemente enthält.

5. Verfahren zum Diagnostizieren der Restlebensdauer eines Sekundärbatteriemoduls (11) nach Anspruch 1, wobei die Ausgabeinformationen Temperaturinformationen enthalten.

6. System zum Diagnostizieren der Restlebensdauer eines Sekundärbatteriemoduls (11),
wobei das System eine Lebensdauerberechnungseinheit (7) umfasst und konfiguriert ist, Folgendes auszuführen:

Erfassen von Ladeinformationen, die Strom, Spannung und Ladezustand ($SOC_b$, $SOC_c$) enthalten, eines Sekundärbatteriemoduls (11);
Erhalten einer gegenwärtigen Kapazität (Q) und eines Innenwiderstands (DCR) des Sekundärbatteriemoduls (11) aus den Ladeinformationen, Berechnen eines Verschlechterungsgrads (SOH, SOHQ, SOHR) des Sekundärbatteriemoduls (11) durch Vergleichen der Kapazität und des Innenwiderstands (DCR) mit ihren Anfangswerten, und Erhalten eines ersten Ergebnisses, in dem der Verschlechterungswert als tatsächlicher Messwert spezifiziert ist;
Erfassen von Ausgabeinformationen des Sekundärbatteriemoduls (11);
Berechnen eines Vorhersagewerts des Verschlechterungsgrads (SOH, SOHQ, SOHR) durch eine Vorhersageformel unter Verwendung der Ausgabeinformationen; und
Erhalten eines zweiten Ergebnisses des Vergleichs des tatsächlichen Messwerts und des Vorhersagewerts,

**14**

wobei:

falls eine Differenz zwischen dem tatsächlichen Messwert und dem Vorhersagewert gleich einem oder kleiner als ein vorgegebener Wert ist, die Lebensdauerberechnungseinheit (7) die Restlebensdauer berechnet;
falls die Differenz zwischen dem tatsächlichen Messwert und dem Vorhersagewert größer als der vorgegebene Wert ist, das System die Vorhersageformel basierend auf dem tatsächlichen Messwerte korrigiert und den Vorhersagewert durch die korrigierte Vorhersageformel berechnet; und
die Lebensdauerberechnungseinheit (7) die Restlebensdauer berechnet.

7. System zum Diagnostizieren der Restlebensdauer eines Sekundärbatteriemoduls (11) nach Anspruch 6, das ferner eine Verschlechterungsschätzungseinheit (6) umfasst,
wobei die Verschlechterungsschätzungseinheit (6) das erste Ergebnis erhält und das zweite Ergebnis an die Lebensdauerberechnungseinheit (7) sendet.

8. System zum Diagnostizieren der Restlebensdauer eines Sekundärbatteriemoduls (11) nach Anspruch 7, das ferner eine Widerstands- und Kapazitätsberechnungseinheit (5) umfasst,
wobei die Widerstands- und Kapazitätsberechnungseinheit (5) das erste Ergebnis an die Verschlechterungsschätzungseinheit (6) sendet.

9. System zum Diagnostizieren der Restlebensdauer eines Sekundärbatteriemoduls (11) nach Anspruch 6, wobei die Ladeinformationen Strom, Spannung und einen Ladezustand ($SOC_b$, $SOC_c$) jedes der das Sekundärbatteriemodul (11) bildenden Batterieelemente enthalten.

10. System zum Diagnostizieren der Restlebensdauer eines Sekundärbatteriemoduls (11) nach Anspruch 9, wobei die Ladeinformationen individuelle Attribute der Batterieelemente enthalten.

11. System zum Diagnostizieren der Restlebensdauer eines Sekundärbatteriemoduls (11) nach Anspruch 6, wobei das Sekundärbatteriemodul (11) eine Energiequelle für ein mobiles Objekt ist und
das System die Ausgabeinformationen von einem zweiten Endgerät (3) erfasst, das von dem ersten Endgerät (12), das in dem mobilen Objekt installiert ist, verschieden ist.

12. System zum Diagnostizieren der Restlebensdauer eines Sekundärbatteriemoduls (11) nach Anspruch 11 wobei:

das erst Endgeräte (12) mehrere Endgeräte umfasst; und
die Ausgabeinformationen von den mehreren Endgeräten an das zweite Endgerät (3) gesendet werden.

13. System zum Diagnostizieren der Restlebensdauer eines Sekundärbatteriemoduls (11) nach Anspruch 6, wobei das System die Ladeinformationen von einem Ladegerät (2) erfasst.

14. System zum Diagnostizieren der Restlebensdauer eines Sekundärbatteriemoduls (11) nach Anspruch 6, das ferner eine Datenbank (44) umfasst, die in der Lage ist, die Ladeinformationen und die Ausgabeinformationen bezüglich mehrerer Sekundärbatteriemodule (11) zu sammeln.

15. System zum Diagnostizieren der Restlebensdauer eines Sekundärbatteriemoduls (11) nach Anspruch 6, wobei die Ausgabeinformationen Temperaturinformationen enthalten.

**Revendications**

1. Procédé de diagnostic de durée de vie résiduelle d'un module de batterie secondaire (11), le procédé comprenant les étapes consistant à :

acquérir des informations de charge incluant un courant, une tension et un état de charge ($SOC_b$, $SOC_c$) d'un module de batterie secondaire (11) ;
obtenir une capacité actuelle (Q) et une résistance interne (DCR) du module de batterie secondaire (11) à partir des informations de charge, calculer un niveau de détérioration (SOH, SOHQ, SOHR) du module de batterie secondaire (11) en comparant la capacité et la résistance interne (DCR) par rapport à leurs valeurs initiales, et spécifier la valeur de détérioration en tant que valeur de mesurage réelle ;
acquérir des informations de sortie du module de batterie secondaire (11) ;
calculer une valeur prédite du niveau de détérioration (SOH, SOHQ, SOHR) au moyen d'une formule de prédiction, à l'aide des informations de sortie ;
le procédé étant **caractérisé en ce qu'**il comprend également les étapes consistant à :

comparer la valeur de mesurage réelle et la valeur prédite ; et
calculer une durée de vie résiduelle, si une différence entre la valeur de mesurage réelle et la valeur prédite est égale ou inférieure à une valeur prédéterminée,
dans lequel, si la différence entre la valeur de mesurage réelle et la valeur prédite est supérieure à la valeur prédéterminée, le procédé doit corriger la formule de prédiction sur la base de la valeur de mesurage réelle et calculer la valeur prédite au moyen de la formule de prédiction corrigée.

2. Procédé de diagnostic de durée de vie résiduelle d'un module de batterie secondaire (11) selon la revendication 1, dans lequel les informations de charge incluent un courant, une tension et un état de charge (SOC_b, SOC_c) de chacun des éléments de batterie constituant le module de batterie secondaire (11).

3. Procédé de diagnostic de durée de vie résiduelle d'un module de batterie secondaire (11) selon la revendication 2, dans lequel les informations de charge incluent des attributs individuels des éléments de batterie.

4. Procédé de diagnostic de durée de vie résiduelle d'un module de batterie secondaire (11) selon la revendication 2, dans lequel la durée de vie résiduelle inclut une valeur de durée de vie résiduelle de chacun des éléments de batterie.

5. Procédé de diagnostic de durée de vie résiduelle d'un module de batterie secondaire (11) selon la revendication 1, dans lequel les informations de sortie incluent des informations de température.

6. Système de diagnostic de durée de vie résiduelle d'un module de batterie secondaire (11), le système comprenant une unité de calcul de durée de vie (7) et étant configurée pour effectuer les opérations suivantes :

acquérir des informations de charge incluant un courant, une tension et un état de charge (SOC_b, SOC_c) d'un module de batterie secondaire (11) ;
obtenir une capacité actuelle (Q) et une résistance interne (DCR) du module de batterie secondaire (11) à partir des informations de charge, calculer un niveau de détérioration (SOH, SOHQ, SOHR) du module de batterie secondaire (11) en comparant la capacité et la résistance interne (DCR) par rapport à leurs valeurs initiales, et obtenir un premier résultat dans lequel la valeur de détérioration est spécifiée en tant que valeur de mesurage réelle ;
acquérir des informations de sortie du module de batterie secondaire (11) ;
calculer une valeur prédite du niveau de détérioration (SOH, SOHQ, SOHR) au moyen d'une formule de prédiction, à l'aide des informations de sortie ; et
obtenir un second résultat de comparaison de la valeur de mesurage réelle et de la valeur prédite, dans lequel :

si une différence entre la valeur de mesurage réelle et la valeur prédite est égale ou inférieure à une valeur prédéterminée, unité de calcul de durée de vie (7) calcule une durée de vie résiduelle ;
si la différence entre la valeur de mesurage réelle et la valeur prédite est supérieure à la valeur prédéterminée, le système corrige la formule de prédiction sur la base de la valeur de mesurage réelle et calcule la valeur prédite au moyen de la formule de prédiction corrigée ; et
l'unité de calcul de durée de vie (7) calcule la durée de vie résiduelle.

7. Système de diagnostic de durée de vie résiduelle d'un module de batterie secondaire (11) selon la revendication 6, comprenant en outre une unité d'estimation de détérioration (6), dans lequel l'unité d'estimation de détérioration (6) obtient le premier résultat et envoie le second résultat à l'unité de calcul de durée de vie (7).

8. Système de diagnostic de durée de vie résiduelle d'un module de batterie secondaire (11) selon la revendication 7, comprenant en outre une unité de calcul de résistance et de capacité (5), dans lequel l'unité de calcul de résistance et de capacité (5) envoie le premier résultat à l'unité d'estimation de détérioration (6).

9.  Système de diagnostic de durée de vie résiduelle d'un module de batterie secondaire (11) selon la revendication 6, dans lequel les informations de charge incluent un courant, une tension et un état de charge ($SOC_b$, $SOC_c$) de chacun des éléments de batterie constituant le module de batterie secondaire (11).

10. Système de diagnostic de durée de vie résiduelle d'un module de batterie secondaire (11) selon la revendication 9, dans lequel les informations de charge incluent des attributs individuels des éléments de batterie.

11. Système de diagnostic de durée de vie résiduelle d'un module de batterie secondaire (11) selon la revendication 6, dans lequel le module de batterie secondaire (11) est une source de puissance d'un objet mobile et le système acquiert les informations de sortie à partir d'un second terminal (3) qui est autre que le premier terminal (12) qui est installé dans l'objet mobile.

12. Système de diagnostic de durée de vie résiduelle d'un module de batterie secondaire (11) selon la revendication 11, dans lequel :

    le premier terminal (12) comprend une pluralité de terminaux ; et
    les informations de sortie sont envoyées depuis la pluralité de terminaux au second terminal (3).

13. Système de diagnostic de durée de vie résiduelle d'un module de batterie secondaire (11) selon la revendication 6, dans lequel le système acquiert les informations de charge à partir d'un chargeur (2).

14. Système de diagnostic de durée de vie résiduelle d'un module de batterie secondaire (11) selon la revendication 6, comprenant en outre une base de données (44) capables d'accumuler les informations de charge et les informations de sortie sur une pluralité de modules du module de batterie secondaire (11).

15. Système de diagnostic de durée de vie résiduelle d'un module de batterie secondaire (11) selon la revendication 6, dans lequel les informations de sortie incluent des informations de température.

# FIG.1

# FIG.2

# FIG.3

# FIG.4

# FIG.5

# FIG.6

# FIG.7

# FIG.8

## FIG.9

## FIG.10

# FIG.11

# FIG.12

# FIG.13

# FIG.14

# FIG.15

# FIG.16A

## FIG.16B

## FIG.16C

EXTRACTING TRAVELING PATTERN

## FIG.17

# FIG.18

BASE DATA

VARIABLE ID

PARAMETER ITEM (L) FOR CALCULATING DETERIORATION

M PIECES

CHARACTERISTIC PARAMETER ITEM (k)

| | 1 | 2 | 3 | 4 | 5 | 6 | ······ | m | 61 | 62 | ······ | 70 |
|---|---|---|---|---|---|---|---|---|---|---|---|---|
| | k1 | k2 | k3 | k4 | k5 | k6 | ······ | km | L1 | L2 | ······ | L10 |
| 1 | $P_{11}$ | $P_{12}$ | $P_{13}$ | $P_{14}$ | $P_{15}$ | $P_{16}$ | ······ | $P_{1m}$ | Ai1 | Ci1 | ······ | 00 |
| 2 | $P_{21}$ | $P_{22}$ | $P_{23}$ | $P_{24}$ | $P_{25}$ | $P_{26}$ | ······ | $P_{2m}$ | Ai2 | Ci2 | ······ | 00 |
| 3 | $P_{31}$ | $P_{32}$ | $P_{33}$ | $P_{34}$ | $P_{35}$ | $P_{36}$ | ······ | $P_{3m}$ | Ai3 | Ci3 | ······ | 00 |
| 4 | $P_{41}$ | $P_{42}$ | $P_{43}$ | $P_{44}$ | $P_{45}$ | $P_{46}$ | ······ | $P_{4m}$ | Ai4 | Ci4 | ······ | 00 |
| 5 | $P_{51}$ | $P_{52}$ | $P_{53}$ | $P_{54}$ | $P_{55}$ | $P_{56}$ | ······ | $P_{5m}$ | Ai5 | Ci5 | ······ | 00 |
| . | . | . | . | . | . | . | ······ | . | . | . | . | . |
| . | . | . | . | . | . | . | ······ | . | . | . | . | . |
| . | . | . | . | . | . | . | ······ | . | . | . | . | . |
| n | $P_{n1}$ | $P_{n2}$ | $P_{n3}$ | $P_{n4}$ | $P_{n5}$ | $P_{n6}$ | ······ | $P_{nm}$ | AiN | CiN | ······ | 00 |

N PIECES

NUMBER

OPERATING CONDITION PARAMETER

INFORMATION FOR ESTIMATING DETERIORATION

**EP 3 916 884 B1**

## REFERENCES CITED IN THE DESCRIPTION

**Patent documents cited in the description**

- JP 5466564 B
- JP 5338591 B